# EUROPEAN PATENT APPLICATION

(11) **EP 4 769 152 A1**
(43) Date of publication of application: **01.07.2026**
(21) Application number: 25221875.5
(22) Date of filing: 09.12.2025
(51) Int. Cl.: G06F 11/10

(54) **STORAGE DEVICE, STORAGE CONTROLLER, AND OPERATING METHOD OF STORAGE CONTROLLER INCLUDING A STATE SHAPING ENGINE**

(30) Priority: 26.12.2024 KR 20240197381
(71) Applicant: Samsung Electronics Co., Ltd., Suwon-si, Gyeonggi-do 16677 (KR)
(72) Inventor: LEE, Dahye, 16677 Suwon-si (KR); HEO, Youngjun, 16677 Suwon-si (KR); KIM, Shihye, 16677 Suwon-si (KR); RA, Youngsuk, 16677 Suwon-si (KR); YI, Hyunju, 16677 Suwon-si (KR)
(74) Representative: Marks & Clerk LLP

(57) **Abstract**

A storage device includes a memory device, and a storage controller configured to control the memory device and communicate with an external host. The storage controller includes a buffer memory configured to store write data received from the external host; a state shaping engine configured to receive the write data from the buffer memory, generate the converted data by performing a front state shaping operation based on the write data, and store the converted data in the buffer memory; and an error correction code (ECC) engine configured to receive the converted data from the buffer memory, generate encoded data by performing an ECC encoding operation based on the converted data, and transmit the encoded data to the memory device.

## Description

### BACKGROUND

The disclosure relates to a semiconductor memory, and particularly, to a storage device, a storage controller, and an operating method of the storage controller.

A semiconductor memory includes a volatile memory device, such as a static random access memory (SRAM) and a dynamic random access memory (DRAM), which loses stored data when power is not supplied, and a nonvolatile memory device, such as a flash memory device, a phase-change RAM (PRAM), a magnetic RAM (MRAM), a resistive RAM (RRAM), and a ferroelectric RAM (FRAM), which maintains stored data even when power is not supplied.

Flash memory is widely used as a storage device, which is a large-capacity storage medium. A storage device stores data under control by a host device, such as a computer, a smartphone, or a smart pad. A storage device includes a device that stores data in a magnetic disk such as a hard disk drive (HDD), and a device that stores data in a semiconductor memory, particularly a nonvolatile memory, such as a solid state drive (SSD) or a memory card.

As a semiconductor manufacturing technology advances, storage devices using a flash memory are more highly integrated and increased in capacity. High integration of storage devices has an advantage of reducing production costs of storage devices. However, as a scale of storage devices decreases due to high integration of the storage devices, various problems that may damage data stored in storage devices arise. Accordingly, reliability of the storage devices may be deteriorated. There is a continuous demand for a method and a device that may improve the reliability of the storage devices.

### SUMMARY

One or more example embodiments of the disclosure provide a storage device, a storage controller, and an operating method of the storage controller which may improve reliability of the storage device.

According to an aspect of an example embodiment of the disclosure, a storage device includes a memory device, and a storage controller configured to control the memory device and communicate with an external host, wherein the storage controller includes a buffer memory configured to store write data received from the external host; a state shaping engine configured to receive the write data from the buffer memory, generate converted data by performing a front state shaping operation based on the write data, and store the converted data in the buffer memory; and an error correction code (ECC) engine configured to receive the converted data from the buffer memory, generate encoded data by performing an ECC encoding operation based on the converted data, and transmit the encoded data to the memory device.

According to an aspect of an example embodiment of the disclosure, an operating method of a storage controller including a buffer memory, a state shaping engine, and an ECC engine includes simultaneously loading, by the state shaping engine, a plurality of logical pages from the buffer memory; generating, by the state shaping engine, a plurality of converted pages by performing a front state shaping operation based on the plurality of logical pages; storing, by the state shaping engine, the plurality of converted pages in the buffer memory; loading, by the ECC engine, the plurality of converted pages from the buffer memory; generating, by the ECC engine, a plurality of encoded pages by performing an ECC encoding operation based on the plurality of converted pages; and transmitting, by the ECC engine, the plurality of encoded pages to an external memory device.

According to an aspect of an example embodiment of the disclosure, a storage controller includes a buffer memory configured to store a plurality of logical pages received from an external host; a state shaping engine configured to simultaneously receive the plurality of logical pages from the buffer memory, generate a plurality of converted pages by performing a front state shaping operation based on the plurality of logical pages, and store the plurality of converted pages in the buffer memory; and an ECC engine configured to receive the plurality of converted pages from the buffer memory, generate a plurality of encoded pages by performing an ECC encoding operation based on the plurality of converted pages, and transmit the plurality of encoded pages to an external memory device.

At least some of the above and other features of the invention are set out in the claims.

### BRIEF DESCRIPTION OF DRAWINGS

Example embodiments will be more clearly understood from the following detailed description taken in conjunction with the accompanying drawings in which:
FIG. 1 is a block diagram illustrating a storage device according to one or more embodiments;
FIG. 2 is a block diagram illustrating a memory device according to one or more embodiments;
FIG. 3 is a block diagram illustrating an example of a memory block according to one or more embodiments;
FIG. 4 is a diagram illustrating an example of a state shaping operation of a storage controller;
FIG. 5 is a diagram illustrating an example of an operation of a storage controller according to one or more embodiments;
FIG. 6 is a diagram illustrating an example of an operation of a storage controller according to one or more embodiments;
FIGS. 7A and FIG. 7B are diagrams illustrating a state shaping operation according to one or more embodiments;
FIG. 8 is a flowchart illustrating an example of an operating method of the storage controller according to one or more embodiments;
FIG. 9 is a diagram illustrating a front state shaping operation of the storage controller according to one or more embodiments;
FIGS. 10A and 10B are diagrams illustrating a front state shaping operation of a storage controller according to one or more embodiments;
FIG. 11 is a diagram illustrating an operation of a state shaping engine according to one or more embodiments;
FIG. 12 is a flowchart illustrating an example of an operation of a state shaping engine according to one or more embodiments;
FIGS. 13 and 14 are diagrams illustrating operations of a storage controller according to one or more embodiments;
FIG. 15 is a diagram illustrating an operation of a storage controller;
FIG. 16 is a diagram illustrating an example of an operation of a storage controller according to one or more embodiments; and
FIG. 17 is a diagram illustrating a system according to one or more embodiments.

### DETAILED DESCRIPTION

Hereinafter, example embodiments are described clearly and in detail such that a person having ordinary skill in the art of the disclosure may easily practice the disclosure. One of ordinary skill would understand that aspects of some embodiments may be combined together or implemented alone.

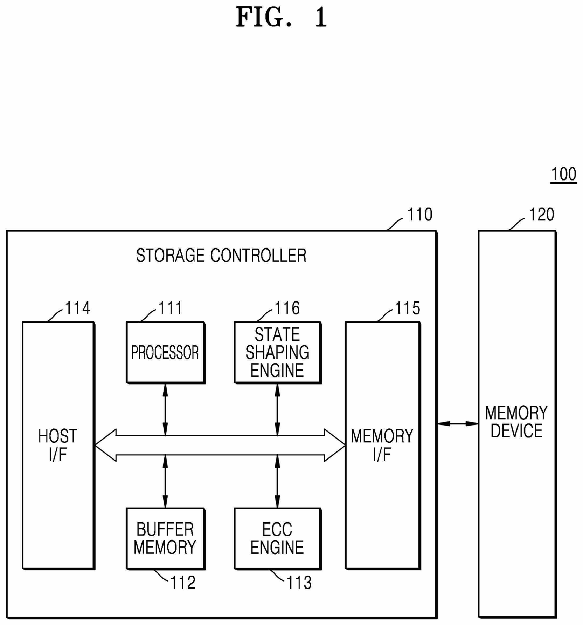

FIG. 1 is a block diagram illustrating a storage device according to one or more embodiments.

Referring to FIG. 1, a storage device 100 may include a storage controller 110 and a memory device 120. The storage controller 110 may operate under control by an external host. For example, the storage controller 110 may store data in the memory device 120 and/or provide data stored in the memory device 120 to the external host under the control by the external host.

The storage controller 110 may include a processor 111, a buffer memory 112, an error correction code (ECC) engine 113, a host interface circuit 114, a memory interface circuit 115, and a state shaping engine 116.

The processor 111 may control overall operations of the storage controller 110. For example, the processor 111 may drive an operating system or firmware for driving the storage controller 110. The processor 111 may generate commands and addresses for controlling the memory device 120 based on a request from a host. The processor 111 may execute one or more commands stored in the buffer memory 112. The processor 111 may drive an operating system or firmware for driving the storage controller 110.

The buffer memory 112 may temporarily store data to be stored in the memory device 120 and/or data read from the memory device 120. The buffer memory 112 may be configured to store various types of information related to an operation of the storage controller 110. For example, the buffer memory 112 may be configured to store a map table for accessing the memory device 120. The buffer memory 112 may store one or more commands. In an embodiment, the buffer memory 112 may include a random access memory. For example, the buffer memory 112 may include a static random access memory (SRAM) or a dynamic random access memory (DRAM).

The ECC engine 113 may perform ECC encoding on user data to be stored in the memory device 120 to generate parity data. The generated parity data may be stored in the memory device 120 together with the user data. The ECC engine 113 may be configured to perform ECC decoding based on user data and parity data read from the memory device 120 to correct an error in the user data.

The host interface circuit 114 may be configured to communicate with a host. In an embodiment, the host interface circuit 114 may be configured to comply with a preset interface, communication protocol, or communication standard between a host and the storage device 100. The preset interface may support at least one of various interfaces, such as a universal serial bus (USB), a small computer system interface (SCSI), peripheral component interconnect PCI) express, advanced technology attachment (ATA), parallel ATA (PATA), serial ATA (SATA), serial attached SCSI (SAS), universal flash storage (UFS), nonvolatile memory express (NVMe), and compute express link (CXL), but the disclosure is not limited thereto.

The memory interface circuit 115 may be configured to access the memory device 120. For example, the memory interface circuit 115 may be configured to access the memory device 120 based on commands and addresses generated by the processor 111 for controlling the memory device 120. In an embodiment, the memory interface circuit 115 may communicate with the memory device 120 based on an interface or protocol defined based on a standard or defined by a manufacturer. In an embodiment, the interface or protocol described above may include a toggle interface or an open NAND flash interface (ONFI).

The memory device 120 may operate under the control by the storage controller 110. In an embodiment, the memory device 120 may be configured based on a NAND flash memory. However, the disclosure is not limited thereto, and the memory device 120 may be configured based on at least one of various nonvolatile memory devices, such as a phase change memory device, a ferroelectric memory device, a magnetic memory device, a resistive memory device, etc.

In an embodiment, memory cells of the memory device 120 may each be a quadruple level cell (QLC) that stores 4-bit data. However, the disclosure is not limited thereto, and each of the memory cells may be implemented with a multi level cell (MLC) that stores 2 bits or a triple level cell (TLC) that stores 3 bits, or each of the memory cells may store more than 4 bits.

Memory cells of the memory device 120 may each have a programmed threshold voltage corresponding to a bit value of data. Among a plurality of threshold voltage states of the memory cells, a certain threshold voltage state may degrade performance, such as reliability or a lifespan of the memory cell. Accordingly, state shaping may be used to reduce a number of bits corresponding to a threshold voltage state that may degrade performance.

The state shaping engine 116 may perform a state shaping operation. The term "state shaping" used in the disclosure may indicate an operation of encoding a pattern of data stored in a memory device. Alternatively, "state shaping" may indicate an operation of reducing a previously determined pattern of data.

In an embodiment, "state shaping" may indicate an encoding operation for adjusting, on a state-by-state basis, a distribution of a threshold voltage formed as write data is programmed into a memory device. In an embodiment, "state shaping" may indicate an operation of reducing a number of memory cells to be programmed to a target threshold voltage state (that is, changing a target threshold voltage state to another threshold voltage state).

In an embodiment, a state shaping operation may indicate an operation of shaping data such that a number of bits corresponding to a certain program state is reduced. The state shaping engine 116 may perform a state shaping operation based on the write data to generate shaped data. The shaped data may include a shaped page data and state shaping parity data. For example, the shaped page data may indicate data obtained by subtracting a number of bits indicating a target threshold voltage state from data received from an external host.

In an embodiment, a state inversion operation may indicate an operation of inverting a state based on the shaped data to generate user data. That is, the state shaping engine 116 may convert the converted page data into user data based on the state shaping parity data.

In an embodiment, the state shaping engine 116 may perform vertical NAND (VNAND) state shaping (VSS) encoding. The VSS encoding may be an operation of encoding data to be stored in the memory device 120 based on a VNAND.

In an embodiment, the storage controller 110 may perform a front state shaping operation and an ECC encoding operation while performing a program operation. The storage controller 110 may perform an ECC decoding operation and a front state inversion operation while performing a read operation. For example, the front state shaping operation may indicate an encoding operation of reducing the number of bits corresponding to a target threshold voltage. The front state inversion operation may indicate a decoding operation for converting the converted data into original user data (or raw data).

The storage controller 110 may perform a front state shaping operation. The storage controller 110 may perform a state shaping operation before ECC encoding. The front state shaping operation may indicate an operation of performing a state shaping operation before ECC encoding.

The storage controller 110 may generate converted data by performing a front state shaping operation and store the converted data in the buffer memory 112. Thereafter, the storage controller 110 may perform ECC encoding based on the converted data stored in the buffer memory 112.

In an embodiment, the state shaping engine 116 may receive write data (or user data) from the buffer memory 112. The state shaping engine 116 may perform a front state shaping operation based on the write data. The state shaping engine 116 may generate the converted data. The state shaping engine 116 may store the converted data in the buffer memory 112.

In an embodiment, the buffer memory 112 may store write data received from an external host. The buffer memory 112 may provide the write data to the state shaping engine 116. The buffer memory 112 may store the converted data received from the state shaping engine 116. The buffer memory 112 may provide the converted data to the ECC engine 113.

The ECC engine 113 may receive the converted data from the buffer memory 112. The ECC engine 113 may perform ECC encoding based on the converted data. The ECC engine 113 may generate ECC parity data by performing ECC encoding. The ECC engine 113 may generate encoded data. The encoded data may include the converted data and the ECC parity data. The ECC engine 113 may transmit the encoded data to the memory device 120. For example, the ECC engine 113 may transmit encoded data to the memory device 120 through the memory interface circuit 115.

As described above, the storage controller 110 may perform the front state shaping operation and the front state inversion operation. That is, the storage controller 110 may perform the state shaping operation before the ECC encoding. The storage controller 110 may perform the state shaping operation first and store the converted data in the buffer memory 112. The storage controller 110 may perform ECC encoding based on the converted data stored in the buffer memory 112.

Accordingly, resources required for the front state shaping operation or the front state inversion operation may be reduced. Reliability of the storage device 100 may be improved. For example, the state shaping engine 116 may not include a separate internal memory. For example, the state shaping engine 116 may not include an SRAM. Hereinafter, the front state shaping operation and the front state inversion operation are described in more detail.

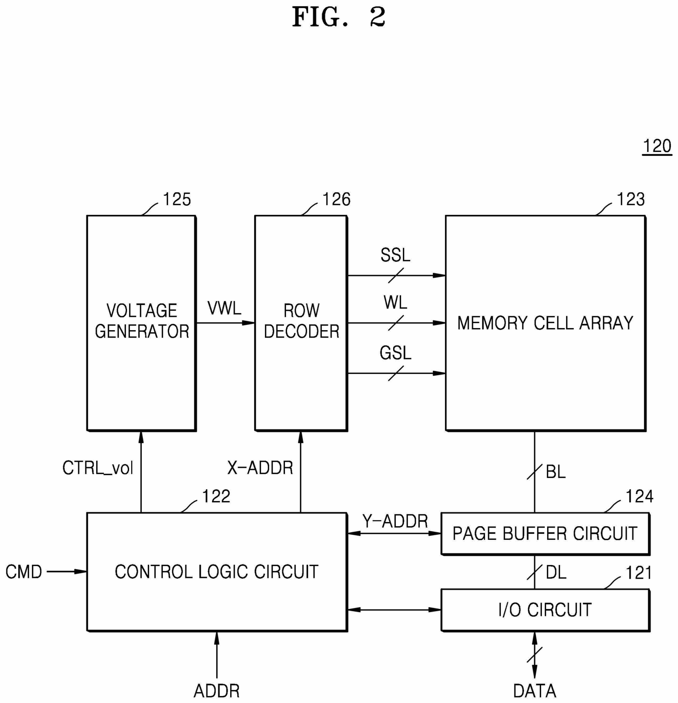

FIG. 2 is a block diagram illustrating a memory device according to one or more embodiments. In an embodiment, the memory device of FIG. 2 may correspond to the memory device 120 of FIG. 1.

Referring to FIG. 2, the memory device 120 may include an input/output (I/O) circuit 121, a control logic circuit 122, a memory cell array 123, a page buffer circuit 124, a voltage generator 125, and a row decoder 126. Although not illustrated in FIG. 2, the memory device 120 may further include a column logic, a pre-decoder, a temperature sensor, a command decoder, an address decoder, and so on.

The control logic circuit 122 may control various operations of components of the memory device 120. The control logic circuit 122 may output various control signals in response to a command CMD and/or an address ADDR from the I/O circuit 121. For example, the control logic circuit 122 may output a voltage control signal CTRL_vol, a row address X-ADDR, and a column address Y-ADDR.

The memory cell array 123 may include a plurality of memory blocks, and each of the plurality of memory blocks may include a plurality of memory cells. The memory cell array 123 may be connected to the page buffer circuit 124 through a plurality of bit lines BL, and may be connected to the row decoder 126 through a plurality of word lines WL, a plurality of string select lines SSL, and a plurality of ground select lines GSL.

In an embodiment, the memory cell array 123 may include a three-dimensional memory cell array, and the three-dimensional memory cell array may include a plurality of NAND strings. The plurality of NAND strings may each include memory cells respectively connected to the plurality of word lines WL vertically stacked on a substrate. In an embodiment, the memory cell array 123 may include a two-dimensional memory cell array, and the two-dimensional memory cell array may include a plurality of NAND strings arranged in row and column directions.

The page buffer circuit 124 may include a plurality of page buffers (n is an integer greater than or equal to 3). The page buffer circuit 124 may be connected to the memory cell array 123 through the plurality of bit lines BL. The plurality of page buffers of the page buffer circuit 124 may be respectively connected to the memory cells through the plurality of bit lines BL. The page buffer circuit 124 may select at least one bit line among the plurality of bit lines BL in response to the column address Y-ADDR. The page buffer circuit 124 may operate as a write driver or a sense amplifier depending on operation modes. For example, during a program operation, the page buffer circuit 124 may apply, to a selected bit line, a bit line voltage corresponding to data to be programmed. During a read operation, the page buffer circuit 124 may detect data stored in a memory cell by detecting a current or voltage of the selected bit line.

The voltage generator 125 may generate various voltages for performing programming, reading, and erasing operations based on the voltage control signal CTRL_vol. For example, the voltage generator 125 may generate a program voltage, a read voltage, a program verification voltage, an erase voltage, and so on as a word line voltage VWL.

The row decoder 126 may select one of the plurality of word lines WL and one of the plurality of string select lines SSL in response to the row address X-ADDR. For example, during a program operation, the row decoder 126 may apply a program voltage and a program verification voltage to a selected word line, and during a read operation, the row decoder 126 may apply a read voltage to a selected word line.

In an embodiment, the I/O circuit 121 may receive a write command. The I/O circuit 121 may receive encoded data from the storage controller 110 in response to the write command. The I/O circuit 121 may provide encoded data to the memory cell array 123 through the page buffer circuit 124. The memory cell array 123 may store the encoded data. The encoded data may be data obtained by performing ECC encoding by the storage controller 110 based on converted data for which a front state shaping operation is completed.

In an embodiment, the I/O circuit 121 may receive a read command. The I/O circuit 121 may receive the encoded data from the memory cell array 123 in response to the read command. The I/O circuit 121 may provide the encoded data to the storage controller 110. The encoded data may be decoded through the ECC decoding and the front state inversion operation of the storage controller 110 and then provided as read data to an external host.

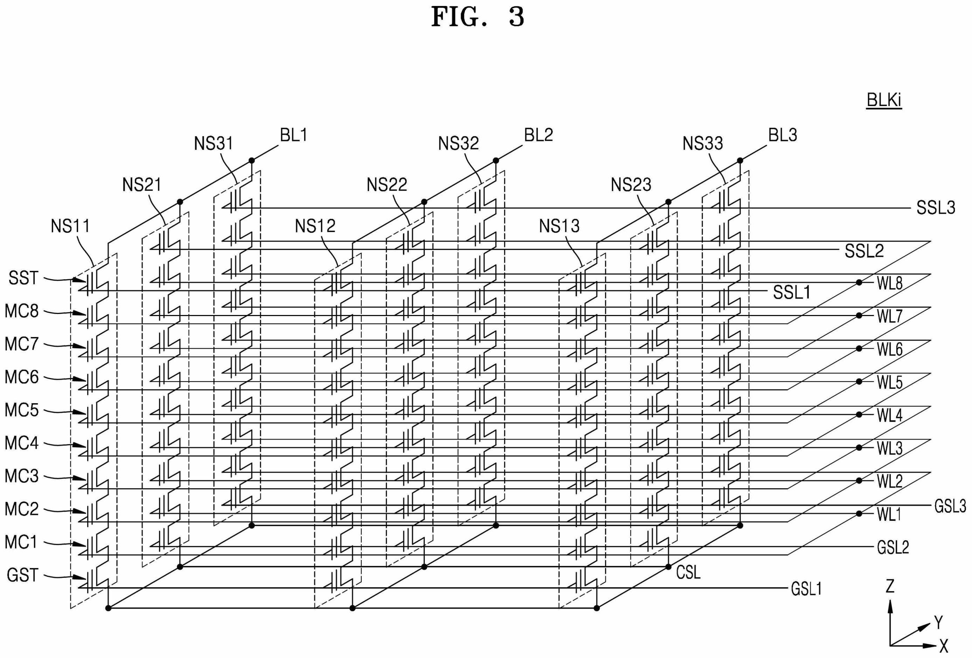

FIG. 3 is a block diagram illustrating an example of a memory block according to one or more embodiments. In an embodiment, the memory block of FIG. 3 may correspond to one of the plurality of memory blocks included in the memory cell array 123.

Referring to FIG. 3, a memory block BLKi indicates a three-dimensional memory block formed in a three-dimensional structure on a substrate. For example, a plurality of memory NAND strings included in the memory block BLKi may be formed in a direction perpendicular to the substrate.

Referring to FIG. 3, the memory block BLKi may include a plurality of memory NAND strings NS11 to NS33 connected between bit lines BL1, BL2, and BL3 and a common source line CSL. Each of the plurality of memory NAND strings NS11 to NS33 may include a string select transistor SST, a plurality of memory cells MC1, MC2, ..., MC8, and a ground select transistor GST. Although FIG. 3 illustrates that each of the plurality of memory NAND strings NS11 to NS33 includes eight memory cells MC1, MC2, ..., MC8, the embodiment is not limited thereto.

The string select transistor SST may be connected to a corresponding string select line among string select lines SSL1, SSL2, and SSL3. Each of the plurality of memory cells MC1, MC2, ..., MC8 may be connected to a corresponding gate line among the gate lines GTL1, GTL2, ..., GTL8. The gate lines GTL1, GTL2, ..., GTL8 may correspond to word lines, and some of the gate lines GTL1, GTL2, ..., GTL8 may correspond to dummy word lines. The ground select transistor GST may be connected to a corresponding ground select line among ground select lines GSL1, GSL2, and GSL3. The string select transistor SST may be connected to a corresponding bit line among the bit lines BL1, BL2, and BL3, and the ground select transistor GST may be connected to the common source line CSL.

Word lines having the same height (for example, WL1) may be commonly connected to each other, and the ground select lines GSL1, GSL2, and GSL3 may be separated from each other, and the string select lines SSL1, SSL2, and SSL3 may be separated from each other. Although FIG. 3 illustrates that the memory block BLKi is connected to eight gate lines GTL1, GTL2, ..., GTL8 and three bit lines BL1, BL2, and BL3, the embodiment is not limited thereto.

In an embodiment, the memory block BLKi may include a plurality of memory pages. For example, first memory cells MC1 of the NAND strings NS11 to NS33 connected to a first gate line GTL1 (or a first word line) may be referred to as a first physical page. In an embodiment, one physical page may correspond to a plurality of logical pages. For example, when the first memory cell MC1 is a QLC that stores information corresponding to four bits, one physical page may correspond to four logical pages. As described above, according to the embodiment, a memory cell array (e.g., 123 in FIG. 2) of the memory device 120 may include the memory block BLKi based on a VNAND.

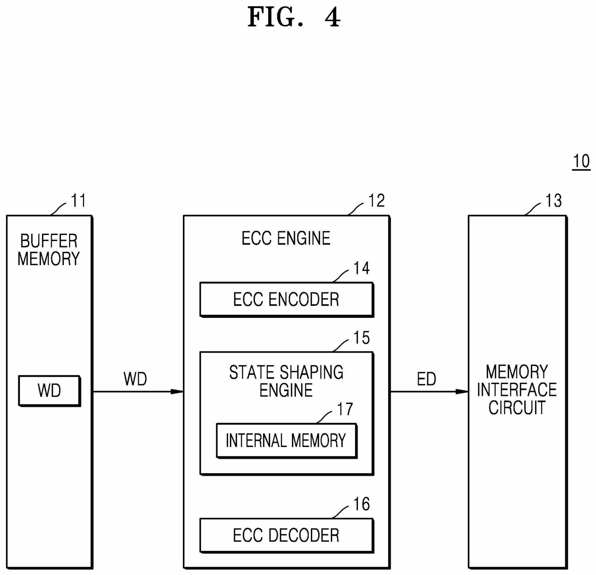

FIG. 4 is a diagram illustrating an example of a state shaping operation of a storage controller.

Referring to FIG. 4, a storage controller 10 may perform a state shaping operation. The storage controller 10 may include a buffer memory 11, an ECC engine 12, and a memory interface circuit 13. The ECC engine 12 may include an ECC encoder 14, a state shaping engine 15, and an ECC decoder 16. The state shaping engine 15 may include an internal memory 17. For example, the internal memory 17 may include an SRAM.

The storage controller 10 may perform an on-the-fly encoding operation. The on-the-fly encoding operation may indicate an operation of performing a state shaping operation and ECC encoding without storing data in the buffer memory 11 during the on-the-fly encoding operation.

The buffer memory 11 may receive write data WD from an external host. The buffer memory 11 may store the write data WD. The buffer memory 11 does not store converted data. The ECC engine 12 may receive the write data WD from the buffer memory 11. The ECC engine 12 may perform a state shaping operation and an ECC encoding operation based on the write data WD. The ECC engine 12 may perform the state shaping operation and the ECC encoding operation to generate encoded data ED. The ECC engine 12 may transmit the encoded data ED to the memory interface circuit 13.

The ECC engine 12 may store data in the buffer memory 11 or may not additionally load data when performing an on-the-fly encoding operation. The ECC engine 12 may skip an operation of storing data in the buffer memory 11. The state shaping engine 15 may store data used for a state shaping operation in the internal memory 17. For example, the state shaping engine 15 may store the write data WD received from the buffer memory 11 in the internal memory 17. The state shaping engine 15 may store state shaping parity data generated by performing the state shaping operation in the internal memory 17. Alternatively, the state shaping engine 15 may store the converted data (that is, including converted page data and state shaping parity data) generated by performing the state shaping operation in the internal memory 17.

For example, the state shaping engine 15 may sequentially perform state shaping operations for a plurality of pages. For example, the state shaping may be an operation of reducing, from a corresponding page among the plurality of pages, a number of target bits indicating threshold voltage states having the same logical value as a logical value of a target threshold voltage state (that is, inverting, page by page, logical values of some of bits indicating states that are likely to correspond to the target threshold voltage state). The target bits may be some of target bits of a previous page. All of the target bits corresponding to a last page may indicate the target threshold voltage state. Each of the memory cells of the memory device 120 may indicate states corresponding to two or more bits.

For example, when the memory cells are each implemented with a QLC that stores four bits, the state shaping engine 15 may perform first state shaping that reduces, from a first logical page corresponding to a least significant bit (LSB), a number of first target bits indicating a logical value equal to the logical value of the target threshold voltage state. Thereafter, the state shaping engine 15 may perform second state shaping that reduces, from a second logical page corresponding to an extra significant bit (ESB), a number of second target bits which are included in the first target bits and indicate a logical value equal to the logical value of the target threshold voltage state. Thereafter, the state shaping engine 15 may perform third state shaping that reduces, from a third logical page corresponding to an upper significant bit (USB), a number of third target bits which are included in the first target bits or the second target bits and indicate a logical value equal to the logical value of the target threshold voltage state. Thereafter, the state shaping engine 15 may perform fourth state shaping that reduces, from a fourth logical page corresponding to a most significant bit (MSB), a number of fourth target bits which are included in the first target bits to the third target bits and indicate a logical value equal to the logical value of the target threshold voltage state.

In an embodiment, one physical page may include a plurality of logical pages. For example, one physical page may include the first logical page and a fourth logical page. The ECC engine 12 may receive write data (that is, the first logical page, a second logical page, a third logical page, and the fourth logical page) from the buffer memory 11. The ECC engine 12 may store the first to fourth logical pages in the internal memory 17. The state shaping engine 15 may load the first logical page from the internal memory 17 and perform a state shaping operation on the first logical page to generate a first converted page. Thereafter, the state shaping engine 15 may load the second logical page from the internal memory 17 and perform a state shaping operation on the second logical page to generate a second converted page. Thereafter, the state shaping engine 15 may load the third logical page from the internal memory 17 and perform a state shaping operation on the third logical page to generate a third converted page. Thereafter, the state shaping engine 15 may load the fourth logical page from the internal memory 17 and perform a state shaping operation on the fourth logical page to generate a fourth converted page.

As described above, the storage controller 10 may require the internal memory 17 when performing an on-the-fly encoding operation. An increase in capacity of the internal memory 17 may be required for multi-plane operation, and so on. Also, when the state shaping is performed sequentially, reliability of the storage device 100 may be reduced.

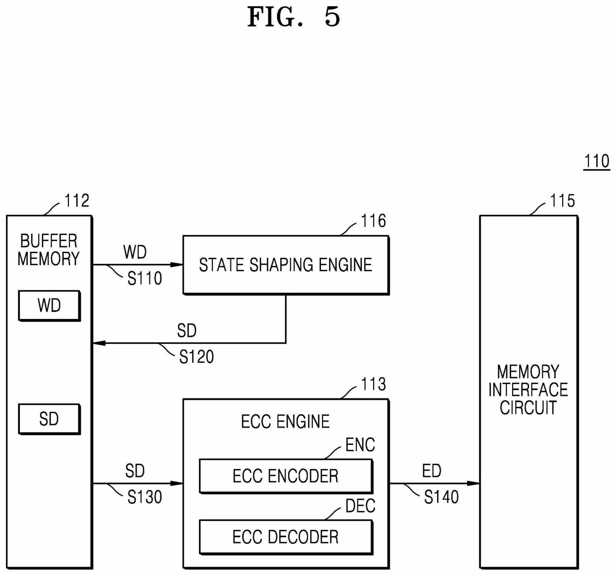

FIG. 5 is a diagram illustrating an example of an operation of a storage controller (e.g., 110 of FIG. 1) according to one or more embodiments.

Referring to FIG. 5, the ECC engine 113 may include an ECC encoder ENC and an ECC decoder DEC. The ECC encoder ENC may generate ECC parity data for received data. The ECC encoder ENC may generate ECC parity data corresponding to converted data SD. The ECC encoder ENC may generate encoded data ED including the converted data SD and the ECC parity data.

The ECC decoder DEC may receive read data and the ECC parity data received from the memory device 120. The ECC decoder DEC may perform an error correction operation based on the ECC parity data. The ECC decoder DEC may generate error-corrected data. The ECC decoder DEC may store the error-corrected data in the buffer memory 112.

The storage controller 110 may perform a front state shaping operation. The storage controller 110 may perform a state shaping operation before ECC encoding. The buffer memory 112 may receive the write data WD from an external host through the host interface circuit 114. The buffer memory 112 may store the write data WD.

The storage controller 110 may perform operation S110 to operation S140 when performing a program operation (or a write operation). The storage controller 110 may perform operation S110 to operation S140 in response to a write request received from an external host.

For example, the storage controller 110 may receive a write request from an external host. The storage controller 110 may receive the write data WD from an external host in response to the write request. The storage controller 110 may store the received write data WD in the buffer memory 112.

In operation S110, the buffer memory 112 may provide the write data WD to the state shaping engine 116. The state shaping engine 116 may load the write data WD from the buffer memory 112. In an embodiment, the state shaping engine 116 may load the write data WD from the buffer memory 112 through an advanced extensible interface (AXI) protocol. For example, the state shaping engine 116 may load the write data WD by performing AXI interleaving.

In an embodiment, the state shaping engine 116 may simultaneously load a plurality of logical pages. For example, a physical page may include a first logical page to a fourth logical page. The write data WD may include the first logical page to the fourth logical page. The state shaping engine 116 may simultaneously load the first logical page to the fourth logical page.

The state shaping engine 116 may perform a front state shaping operation based on the write data WD. The state shaping engine 116 may generate the converted data SD based on the write data WD. In an embodiment, the state shaping engine 116 may perform the front state shaping operation based on the first logical page to the fourth logical page. The state shaping engine 116 may simultaneously perform front state shaping operations for the first logical page to the fourth logical page. In an embodiment, the state shaping engine 116 may simultaneously perform comparison operations to perform the front state shaping operations for the first logical page to the fourth logical page. For example, the state shaping engine 116 may simultaneously perform the front state shaping operations for all of the first logical page to the fourth logical page through a simultaneous comparison algorithm.

In an embodiment, the state shaping engine 116 may perform the front state shaping operation (or front state shaping encoding) to generate the converted data SD including converted page data and state shaping parity data. For example, the state shaping engine 116 may simultaneously perform front state shaping operations for the first logical page to the fourth logical page to generate a first converted page to a fourth converted page. For example, the first converted page may include first converted page data and first state shaping parity data. The first converted page data may indicate data obtained by performing front state shaping for the first logical page. The second converted page may include second converted page data and second state shaping parity data. The second converted page data may indicate data obtained by performing front state shaping for the second logical page. The third converted page may include third converted page data and third state shaping parity data. The third converted page data may indicate data obtained by performing front state shaping for the third logical page. The fourth converted page may include fourth converted page data and the fourth state shaping parity data. The fourth converted page data may indicate data obtained by performing front state shaping for the fourth logical page.

In operation S120, the state shaping engine 116 may store the converted data SD in the buffer memory 112. The state shaping engine 116 may transmit the converted data SD to the buffer memory 112. The buffer memory 112 may store the converted data SD. For example, the converted data SD may include the first converted page to the fourth converted page.

In operation S130, the buffer memory 112 may provide the converted data SD to the ECC engine 113. The ECC engine 113 may load the converted data SD from the buffer memory 112. The ECC engine 113 may perform ECC encoding based on the converted data SD. The ECC engine 113 may perform ECC encoding based on the converted data SD to generate the encoded data ED. The encoded data ED may include the converted data SD and ECC parity data. The encoded data ED may include a first encoded page, a second encoded page, a third encoded page, and a fourth encoded page.

For example, the ECC engine 113 may receive the first converted page to the fourth converted page. The ECC engine 113 may perform an ECC encoding operation on the first converted page to the fourth converted page. The ECC engine 113 may generate the first encoded page to the fourth encoded page.

In operation S140, the ECC engine 113 may transmit the encoded data ED to the memory interface circuit 115. The ECC engine 113 may transmit the encoded data ED to the memory device 120 through the memory interface circuit 115. For example, the storage controller 110 may transmit a program command and the encoded data ED to the memory device 120. The memory device 120 may receive the program command and the encoded data ED. The memory device 120 may store the encoded data ED in the memory cell array 123.

As described above, the storage controller 110 may perform a front state shaping operation. The storage controller 110 may reduce resources required for the front state shaping operation. Reliability of the storage device 100 may be improved. The state shaping engine 116 may not include a separate internal memory.

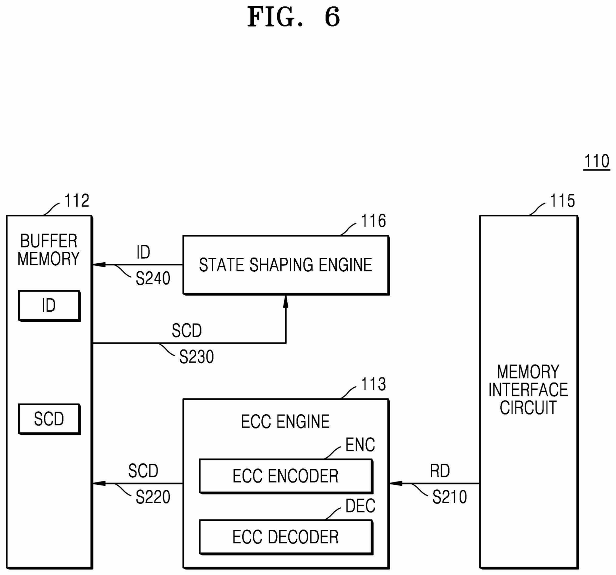

FIG. 6 is a diagram illustrating an example of an operation of a storage controller (e.g., 110 of FIG. 1) according to one or more embodiments.

Referring to FIG. 6, the storage controller 110 may perform operation S210 to operation S240 when performing a read operation. The storage controller 110 may perform operation S210 to operation S240 in response to a read request received from an external host. The storage controller 110 may perform an ECC decoding operation and a front state inversion operation during a read operation.

For example, the storage controller 110 may receive a read request from an external host. In response to the read request, the storage controller 110 may transmit a read command to the memory device 120. The memory device 120 may receive the read command. In response to the read command, the memory device 120 may read the read data RD from the memory cell array 123. The memory device 120 may transmit the read data RD to the storage controller 110. The storage controller 110 may receive the read data RD. The read data RD may be encoded data. The read data RD may include converted read data and ECC parity data.

In operation S210, the memory interface circuit 115 may transmit the read data RD to the ECC engine 113. The ECC engine 113 may receive the read data RD. The ECC engine 113 may perform an error correction operation based on the read data RD. The ECC engine 113 may perform ECC decoding based on the read data RD. The ECC engine 113 may perform an error correction operation on the converted read data based on ECC parity data. The ECC engine 113 may generate converted and corrected data SCD.

In operation S220, the ECC engine 113 may store the converted and corrected data SCD in the buffer memory 112. The ECC engine 113 may transmit the converted and corrected data SCD to the buffer memory 112. The buffer memory 112 may receive the converted and corrected data SCD. The buffer memory 112 may store the converted and corrected data SCD. For example, the converted and corrected data SCD may be ECC decoded data.

In operation S230, the buffer memory 112 may provide the converted and corrected data SCD to the state shaping engine 116. The state shaping engine 116 may load the converted and corrected data SCD from the buffer memory 112. The state shaping engine 116 may perform a front state inversion operation (that is, front state shaping decoding) based on the converted and corrected data SCD. The state shaping engine 116 may perform a state inversion operation based on the converted and corrected data SCD. The state shaping engine 116 may convert the converted page data into user data based on the state shaping parity data included in the converted and corrected data SCD. The state shaping engine 116 may generate inverted data ID.

In operation S240, the state shaping engine 116 may store the inverted data ID in the buffer memory 112. In an embodiment, the state shaping engine 116 may transmit the inverted data ID directly to an external host without storing the inverted data ID in the buffer memory 112.

As described above, the ECC engine 113 may receive the read data RD from the memory device 120. The ECC engine 113 may perform an ECC decoding operation based on the read data RD to generate decoded data. The ECC engine 113 may store the decoded data in the buffer memory 112. The state shaping engine 116 may perform a front state inversion operation based on the decoded data stored in the buffer memory 112 to generate the inverted data ID. The inverted data ID may be transmitted to an external host.

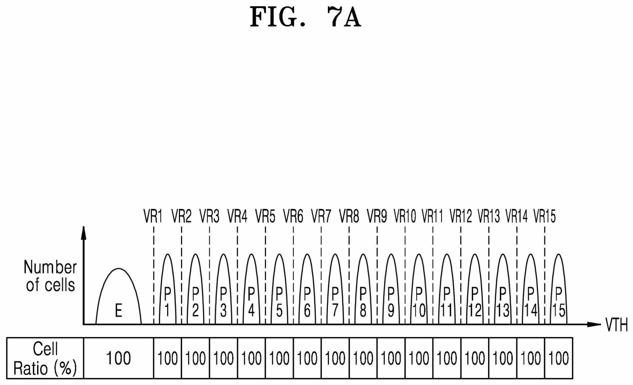

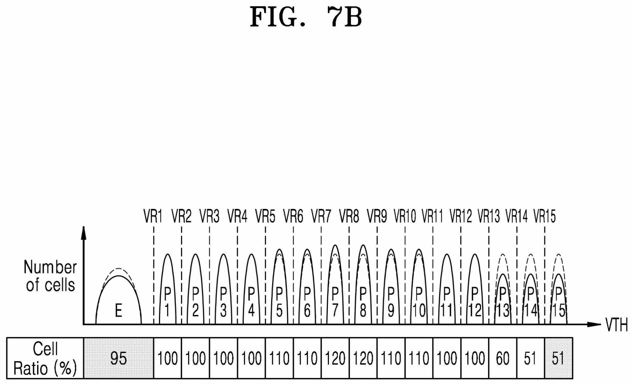

FIGS. 7A and 7B are diagrams illustrating a state shaping operation according to one or more embodiments.

Referring to FIGS. 1, 7A, and 7B, the storage controller 110 may perform a state shaping operation. In an embodiment, the storage controller 110 may perform encoding to reduce a number of memory cells corresponding to a program state with a high error occurrence rate and increase a number of memory cells corresponding to another program state. The storage controller 110 may reduce a number of bits indicating a logical value equal to a logical value of a target threshold voltage state. For example, the storage controller 110 may perform a state shaping operation to reduce a number of bit patterns of a highest program state P15.

Horizontal axes of the graphs of FIGS. 7A and 7B represent a threshold voltage (for example, a level of the threshold voltage), and vertical axes represent a number of memory cells. A QLC may have one of an erasure state E and first to fifteenth program states P1, P2, P3, P4, P5, P6, P7, P8, P9, P10, P11, P12, P13, P14, and P15 in which a level of the threshold voltage sequentially increases. In the QLC, a first read voltage VR1 may be a voltage for distinguishing between the erasure state E and the first program state P1. Similarly, second to fifteenth read voltages VR2 to VR15 may be voltages respectively for distinguishing second to fifteenth program states from previous states (states having previous low threshold voltage levels).

In an embodiment, a physical page corresponding to a QLC storing four bits may correspond to first, second, third, and fourth logical pages. In the QLC, the first logical page may indicate an LSB, the second logical page may indicate an ESB, the third logical page may indicate a USB, and the fourth logical page may indicate an MSB. In other words, memory cells connected to the same word line may store physical page data. The physical page data may include first to fourth logical page data.

In an embodiment, when performing VSS encoding for QLC-based memory cells, a target threshold voltage state may be the fifteenth program state P15. For example, the QLC may have one of the erasure state E and the first to fifteenth program states P1, P2, P3, P4, P5, P6, P7, P8, P9, P10, P11, P12, P13, P14, and P15. A target threshold voltage of the VSS encoding may be the fifteenth program state P15, which is a state having a highest corresponding voltage level among a plurality of threshold voltage states that a QLC may have.

As described above, the states and read voltages of a QLC are described. However, the disclosure is not limited thereto, and a person skilled in the art to which the disclosure pertains would understand that read voltages respectively corresponding to logical pages may be variously modified, and one memory cell may be implemented with an MLC storing two bits, a TLC storing three bits, or one memory cell may store more than four bits.

FIG. 7A illustrates an example of equal shaping in which the same number of memory cells are allocated to each of the erasure states to the fifteenth program states E to P15 when programming selected memory cells. FIG. 7B illustrates an example in which memory cells in the erasure state E and memory cells in upper program states (e.g., P13, P14, P15) with relatively high threshold voltages are reduced. However, the disclosure is not limited thereto, and various types of state shaping may be applied to word lines in which degradation of various characteristics is detected. Here, it is assumed that memory cells of the memory device 120 are QLCs, each having 16 threshold voltage states. However, the disclosure is not limited thereto.

Referring to FIG. 7A, when uniform conversion is applied, an equal or similar number of memory cells in the selected region may be allocated for each of the erasure state to the fifteenth program state E to P15. Here, a cell ratio represents a ratio of a number of memory cells included in a corresponding state to a basic value. Here, the basic value indicates a number of memory cells included in each state when the same number of memory cells is allocated to all states. That is, when the cell ratio is 100 %, it may be understood as an equal shaping in which state shaping is not to be applied to a corresponding state. That is, when the equal shaping is applied, the same number of memory cells are included in all program states when a program operation is completed.

Referring to FIG. 7B, a specific value of a cell ratio is only an example, and the disclosure is not limited thereto. For example, a cell ratio of the erasure state E may be 95 %. That is, a number of memory cells having the erasure state E after programming among memory cells connected to a word line WLj is reduced by only 5 % compared to a case where the equal shaping is applied. A cell ratio of each of the program states P14 and P15 corresponding to a relatively high threshold voltage level may be 51 %. That is, numbers of memory cells that are programmed to the program states P14 and P15 may each be reduced by 49 % compared to a case where the equal shaping is applied. A cell ratio of the program state P13 may be 60 %. That is, a number of memory cells that are programmed to the program state P13 is reduced by 40 % compared to a case where the equal shaping is applied.

For example, a cell ratio of each of the program states P7 and P8 may be 120 %. That is, numbers of memory cells having the program states P7 and P8 after programming among the memory cells connected to the word line WLj may each increase by 20 % compared to a case where the equal shaping is applied. A cell ratio of each of the program states P5, P6, P9, and P10 may be 110 %. That is, numbers of memory cells having the program states P5, P6, P9, and P10 after programming among the memory cells connected to the word line WLj may each increase by 10 % compared to a case where the equal shaping is applied. Cell ratios of the program states P1, P2, P3, P4, P11, and P12 may each be 100 %. In this case, it means that numbers of memory cells having the program states P1, P2, P3, P4, P11, and P12 after programming are equal to a case where the equal shaping is applied.

In an embodiment, according to the state shaping of the memory cells connected to the word line WLi, a number of memory cells included in the erasure state E may be reduced. By reducing the number of memory cells in the erasure state E, degradation of characteristics due to read disturbance may be reduced.

In an embodiment, according to the state shaping of the memory cells connected to the word line WLj, the numbers of memory cells included in the upper program states P13, P14, and P15, each having a relatively high threshold voltage, may be reduced. The memory cells in the upper program states P13, P14, and P15 exhibit a significant drop in threshold voltage due to charge leakage after programming. Therefore, by reducing the numbers of memory cells in the upper program states P13, P14, and P15, reliability degradation due to charge leakage may be reduced.

As described above, the storage controller 110 may perform a front state shaping operation. The storage controller 110 may perform a state shaping operation before ECC encoding. The storage controller 110 may perform a front state shaping operation to reduce the number of memory cells corresponding to a program state in which reliability may be reduced. The storage controller 110 may perform a front state shaping operation to reduce a number of bits corresponding to the target threshold voltage.

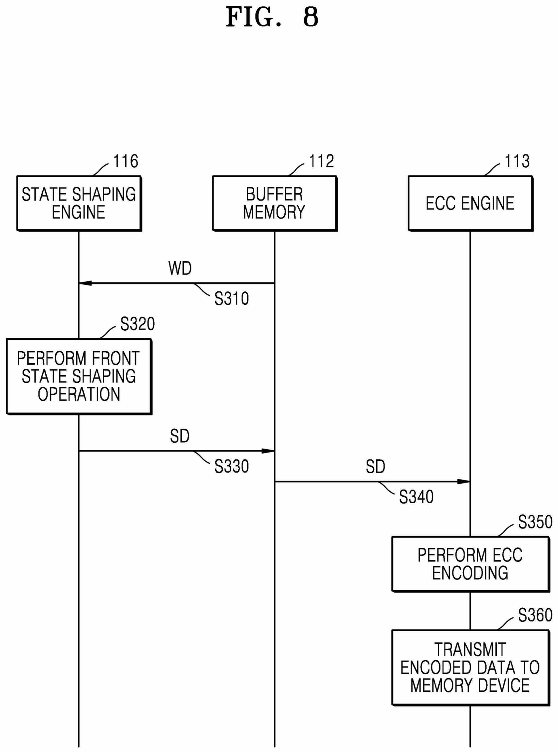

FIG. 8 is a flowchart illustrating an example of an operating method of a storage controller (e.g., 110 of FIG. 1) according to one or more embodiments.

Referring to FIG. 8, in operation S310, the buffer memory 112 may provide the write data WD to the state shaping engine 116. The state shaping engine 116 may load the write data WD from the buffer memory 112. In operation S320, the state shaping engine 116 may perform a front state shaping operation. The state shaping engine 116 may perform the front state shaping operation based on the write data WD. The state shaping engine 116 may generate the converted data SD. The state shaping engine 116 may convert the write data WD into the converted page data and generate state shaping parity data. The converted data SD may include the converted page data and the state shaping parity data.

In operation S330, the state shaping engine 116 may store the converted data SD in the buffer memory 112. In operation S340, the buffer memory 112 may provide the converted data SD to the ECC engine 113. The ECC engine 113 may load the converted data SD from the buffer memory 112. In operation S350, the ECC engine 113 may perform an ECC encoding operation. The ECC engine 113 may perform ECC encoding based on the converted data SD. The ECC engine 113 may generate ECC parity data by performing ECC encoding. The ECC engine 113 may generate the encoded data ED including the converted data SD and the ECC parity data. In operation S360, the ECC engine 113 may transmit the encoded data ED to the memory device 120. The ECC engine 113 may transmit a program command and the encoded data ED to the memory device 120.

As described above, the state shaping engine 116 may simultaneously load a plurality of logical pages from the buffer memory 112. The state shaping engine 116 may perform a front state shaping operation based on the plurality of logical pages to generate a plurality of converted pages. The state shaping engine 116 may store the plurality of converted pages in the buffer memory 112. The ECC engine 113 may load the plurality of converted pages from the buffer memory 112. The ECC engine 113 may perform an ECC encoding operation based on the plurality of converted pages to generate a plurality of encoded pages. The ECC engine 113 may transmit the plurality of encoded pages to a memory device. Accordingly, internal resources (for example, internal memories) of the storage controller 110 may be reduced. Also, a storage device may be improved in reliability.

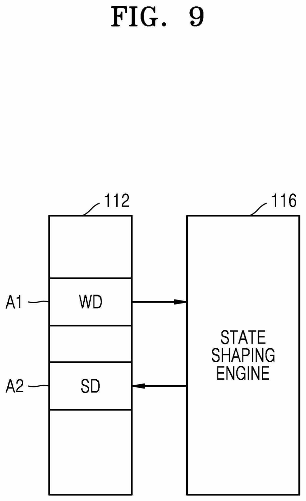

FIG. 9 is a diagram illustrating a front state shaping operation of a storage controller (e.g., 110 of FIG. 1) according to one or more embodiments.

Referring to FIG. 9, the storage controller 110 may store the write data WD in a first region A1 of the buffer memory 112. The storage controller 110 may store the converted data SD in a second region A2 of the buffer memory 112. The second region A2 may be different from the first region A1.

For example, the storage controller 110 may receive the write data WD from an external host. The storage controller 110 may store the write data WD in the first region A1 of the buffer memory 112. The state shaping engine 116 may load the write data WD stored in the first region A1 of the buffer memory 112. The state shaping engine 116 may perform a front state shaping operation based on the write data WD. The state shaping engine 116 may convert the write data WD into converted page data. The state shaping engine 116 may generate state shaping parity data. The state shaping engine 116 may generate the converted data SD including the converted page data and the state shaping parity data.

In an embodiment, the state shaping engine 116 may store the converted data SD in the second region A2 of the buffer memory 112 instead of the first region A1 where the write data WD is stored. The state shaping engine 116 may newly allocate the second region A2 of the buffer memory 112 to store the converted data SD. The state shaping engine 116 may store the converted data SD in the second region A2. The ECC engine 113 may load the converted data SD from the second region A2.

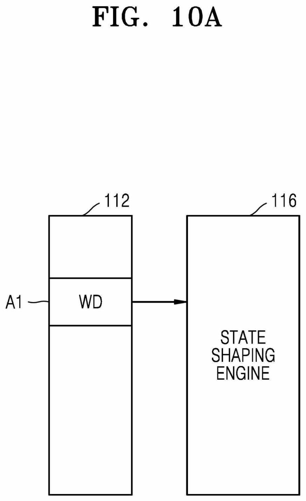

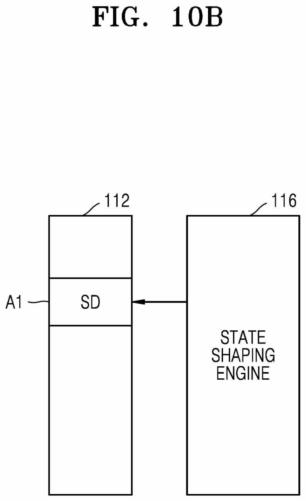

FIGS. 10A and 10B are diagrams illustrating a front state shaping operation of a storage controller (e.g., 110 of FIG. 1) according to one or more embodiments.

Referring to FIGS. 1, 10A, and 10B, the storage controller 110 may store the write data WD in the first region A1 of the buffer memory 112. The storage controller 110 may store the converted data SD in the first region A1 of the buffer memory 112. That is, the storage controller 110 may store the converted data SD in a region where the write data WD is stored. The storage controller 110 may perform overwrite. That is, the storage controller 110 may perform an in-place update for the write data WD or the converted data SD.

For example, the storage controller 110 may receive the write data WD from an external host. The storage controller 110 may store the write data WD in the first region A1 of the buffer memory 112. The state shaping engine 116 may load the write data WD stored in the first region A1 of the buffer memory 112. The state shaping engine 116 may perform a front state shaping operation based on the write data WD. The state shaping engine 116 may convert the write data WD into converted page data. The state shaping engine 116 may generate state shaping parity data. The state shaping engine 116 may generate the converted data SD including the converted page data and the state shaping parity data.

In an embodiment, the state shaping engine 116 may store the converted data SD in the first region A1 where the write data WD is stored. The state shaping engine 116 may skip allocation of the second region A2 and overwrite the converted data SD onto the write data WD. The ECC engine 113 may load the converted data SD from the first region A1.

As described above, the state shaping engine 116 may store the converted data SD in the first region A1 where the write data WD is stored. Alternatively, the state shaping engine 116 may store the converted data SD in the second region A2 different from the first region A1 where the write data is stored.

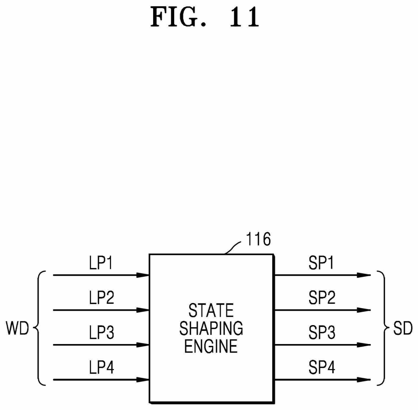

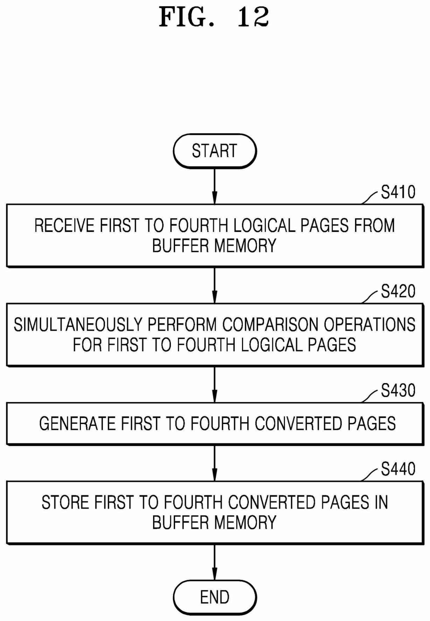

FIG. 11 is a diagram illustrating an operation of a state shaping engine (e.g., 116 of FIG. 1) according to one or more embodiments. FIG. 12 is a flowchart illustrating an example of an operation of a state shaping engine (e.g., 116 of FIG. 1) according to one or more embodiments.

Referring to FIGS. 1, 11, and 12, the state shaping engine 116 may perform a front state shaping operation. The state shaping engine 116 may receive the write data WD from the buffer memory 112. The state shaping engine 116 may store the converted data SD in the buffer memory 112.

In operation S410, the state shaping engine 116 may receive first, second, third, and fourth logical pages LP1, LP2, LP3, and LP4 from the buffer memory 112. For example, the write data WD may include the first to fourth logical pages LP1 to LP4. The state shaping engine 116 may simultaneously receive all of the first to fourth logical pages LP1 to LP4 from the buffer memory 112. The state shaping engine 116 may simultaneously load all of the first to fourth logical pages LP1 to LP4 from the buffer memory 112.

In an embodiment, the state shaping engine 116 may simultaneously load all of the first to fourth logical pages LP1 to LP4 from the buffer memory 112 through an advanced extensible interface (AXI) protocol. For example, the state shaping engine 116 may simultaneously load all of the first to fourth logical pages LP1 to LP4 by performing AXI interleaving.

In operation S420, the state shaping engine 116 may simultaneously perform comparison operations for the first to fourth logical pages LP1 to LP4. The state shaping engine 116 may simultaneously receive the first to fourth logical pages LP1 to LP4 from the buffer memory 112. Accordingly, the state shaping engine 116 may simultaneously perform comparison operations based on the first to fourth logical pages LP1 to LP4. The state shaping engine 116 may perform a front state shaping operation by using a simultaneous comparison algorithm for the first to fourth logical pages LP1 to LP4. The state shaping engine 116 may perform front state shaping operations for the first to fourth logical pages LP1 to LP4 in parallel.

In operation S430, the state shaping engine 116 may generate first, second, third, and fourth converted pages SP1, SP2, SP3, and SP4. The state shaping engine 116 may generate the converted data SD. The converted data SD may include the first to fourth converted pages SP1 to SP4.

In an embodiment, the first converted page SP1 may include first converted page data converted from the first logical page LP1, and first state shaping parity data. The second converted page SP2 may include second converted page data converted from the second logical page LP2, and second state shaping parity data. The third converted page SP3 may include third converted page data converted from the third logical page LP3, and third state shaping parity data. The fourth converted page SP4 may include fourth converted page data converted from the fourth logical page LP4, and fourth state shaping parity data.

In operation S440, the state shaping engine 116 may store the first to fourth converted pages SP1 to SP4 in the buffer memory 112. Thereafter, the ECC engine 113 may load the first to fourth converted pages SP1 to SP4, which are the converted data SD, from the buffer memory 112.

In an embodiment, the first to fourth state shaping parity data may be used for a state shaping decoding operation of a read operation. For example, the state shaping engine 116 may perform a front state inversion operation based on the first state shaping parity data to convert the first converted page data into the first logical page LP1. The state shaping engine 116 may perform the front state inversion operation based on the second state shaping parity data to convert the second converted page data into the second logical page LP2. The state shaping engine 116 may perform the front state inversion operation based on the third state shaping parity data to convert the third converted page data into the third logical page LP3. The state shaping engine 116 may perform the front state inversion operation based on the fourth state shaping parity data to convert the fourth converted page data into the fourth logical page LP4.

As described above, the state shaping engine 116 may receive the write data WD from the buffer memory 112 rather than an internal memory to simultaneously load a plurality of logical pages. The state shaping engine 116 may apply an algorithm optimized for simultaneous comparison. The state shaping engine 116 may perform a front state shaping operation on the plurality of logical pages by using a simultaneous comparison algorithm to generate a plurality of converted pages. Accordingly, a storage device may be improved in reliability.

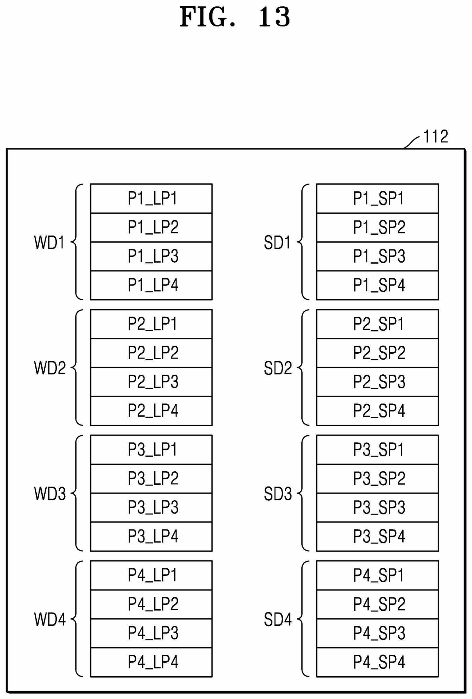

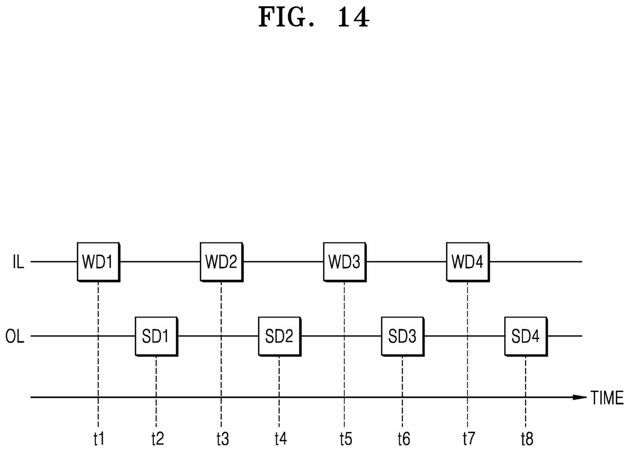

FIGS. 13 and 14 are diagrams illustrating an operation of a storage controller according to one or more embodiments.

Referring to FIGS. 1, 13, and 14, the memory device 120 may include a plurality of planes. In an embodiment, the memory cell array 123 of the memory device 120 may include first to fourth planes. For example, each of the first to fourth planes may include a plurality of memory blocks. The plurality of memory blocks included in the same plane (for example, the first plane) may be configured to share the same bit line, but the disclosure is not limited thereto.

Each of the plurality of memory blocks may be configured to store a plurality of pages. For example, each of the plurality of memory blocks may include a plurality of memory cells, and the plurality of memory cells may be connected to a plurality of word lines. Memory cells connected to one word line may be configured to store at least one page. A number of pages stored in the memory cells connected to one word line may change depending on methods of programming the memory cells (for example, an SLC, an MLC, a TLC, a QLC, and so on).

In an embodiment, the storage device 100 may perform a multi-plane operation. The storage device 100 may perform a multi-plane program operation and a multi-plane read operation.

For example, the storage controller 110 may transmit a multi-plane program command to the memory device 120. Thereafter, the storage controller 110 may transmit first page data of a first plane, transmit first page data of a second plane, transmit first page data of a third plane, and transmit first page data of a fourth plane. Thereafter, the storage controller 110 may transmit second page data of the first plane, transmit second page data of the second plane, transmit second page data of the third plane, and transmit second page data of the fourth plane. Thereafter, the storage controller 110 may transmit third page data of the first plane, transmit third page data of the second plane, transmit third page data of the third plane, and transmit third page data of the fourth plane. Thereafter, the storage controller 110 may transmit fourth page data of the first plane, transmit fourth page data of the second plane, transmit fourth page data of the third plane, and transmit fourth page data of the fourth plane.

In an embodiment, the storage device 100 may receive first, second, third, and fourth write data WD1, WD2, WD3, and WD4 from an external host. The first write data WD1 may correspond to the first plane, the second write data WD2 may correspond to the second plane, the third write data WD3 may correspond to the third plane, and the fourth write data WD4 may correspond to the fourth plane. The buffer memory 112 may store the first, second, third, and fourth write data WD1, WD2, WD3, and WD4.

The first write data WD1 may include a first logical page P1_LP1 of the first plane, a second logical page P1_LP2 of the first plane, a third logical page P1_LP3 of the first plane, and a fourth logical page P1_LP4 of the first plane. The second write data WD2 may include a first logical page P2_LP1 of the second plane, a second logical page P2_LP2 of the second plane, a third logical page P2_LP3 of the second plane, and a fourth logical page P2_LP4 of the second plane. The third write data WD3 may include a first logical page P3_LP1 of the third plane, a second logical page P3_LP2 of the third plane, a third logical page P3_LP3 of the third plane, and a fourth logical page P3_LP4 of the third plane. The fourth write data WD4 may include a first logical page P4_LP1 of the fourth plane, a second logical page P4_LP2 of the fourth plane, a third logical page P4_LP3 of the fourth plane, and a fourth logical page P4_LP4 of the fourth plane.

In an embodiment, the state shaping engine 116 may receive the first to fourth write data WD1 to WD4 from the buffer memory 112 through an input line IL. The state shaping engine 116 may transmit first, second, third, and fourth converted data SD1, SD2, SD3, and SD4 to the buffer memory 112 through an output line OL.

In an embodiment, the state shaping engine 116 may receive the first to fourth write data WD1 to WD4 from the buffer memory 112 through an input/output line. The state shaping engine 116 may transmit the first, second, third, and fourth converted data SD1, SD2, SD3, and SD4 to the buffer memory 112 through the input/output line.

The state shaping engine 116 may receive the first write data WD1 from the buffer memory 112 at a first point in time t1. The state shaping engine 116 may perform a front state shaping operation on the first write data WD1, generate the first converted data SD1, and store the first converted data SD1 in the buffer memory 112. The state shaping engine 116 may transmit the first converted data SD1 to the buffer memory 112 at a second point in time t2. The first converted data SD1 may include a first converted page P1_SP1 of the first plane, a second converted page P1_SP2 of the first plane, a third converted page P1_SP3 of the first plane, and a fourth converted page P1_SP4 of the first plane.

The state shaping engine 116 may receive the second write data WD2 from the buffer memory 112 at a third point in time t3. The state shaping engine 116 may perform a front state shaping operation on the second write data WD2, generate the second converted data SD2, and store the second converted data SD2 in the buffer memory 112. The state shaping engine 116 may transmit the second converted data SD2 to the buffer memory 112 at a fourth point in time t4. The second converted data SD2 may include a first converted page P2_SP1 of the second plane, a second converted page P2_SP2 of the second plane, a third converted page P2_SP3 of the second plane, and a fourth converted page P2_SP4 of the second plane.

The state shaping engine 116 may receive the third write data WD3 from the buffer memory 112 at a fifth point in time t5. The state shaping engine 116 may perform a front state shaping operation on the third write data WD3, generate the third converted data SD3, and store the third converted data SD3 in the buffer memory 112. The state shaping engine 116 may transmit the third converted data SD3 to the buffer memory 112 at a sixth point in time t6. The third converted data SD3 may include a first converted page P3_SP1 of the third plane, a second converted page P3_SP2 of the third plane, a third converted page P3_SP3 of the third plane, and a fourth converted page P3_SP4 of the third plane.

The state shaping engine 116 may receive the fourth write data WD4 from the buffer memory 112 at a seventh point in time t7. The state shaping engine 116 may perform a front state shaping operation on the fourth write data WD4, generate the fourth converted data SD4, and store the fourth converted data SD4 in the buffer memory 112. The state shaping engine 116 may transmit the fourth converted data SD4 to the buffer memory 112 at an eighth point in time t8. The fourth converted data SD4 may include a first converted page P4_SP1 of the fourth plane, a second converted page P4_SP2 of the fourth plane, a third converted page P4_SP3 of the fourth plane, and a fourth converted page P4_SP4 of the fourth plane.

The buffer memory 112 may store the first to fourth converted data SD1 to SD4. The ECC engine 113 may sequentially load the first to fourth converted data SD1 to SD4 stored in the buffer memory 112. The ECC engine 113 may load the converted data and perform ECC encoding to generate encoded data. The ECC engine 113 may transmit the encoded data to the memory device 120.

For example, the ECC engine 113 may load the first converted page P1_SP1 of the first plane from the buffer memory 112, generate a first encoded page of the first plane by performing an ECC encoding operation on the first converted page P1_SP1 of the first plane, and transmit the first encoded page of the first plane to the memory device 120. Thereafter, the ECC engine 113 may load the first converted page P2_SP1 of the second plane from the buffer memory 112, generate a first encoded page of the second plane by performing an ECC encoding operation on the first converted page P2_SP1 of the second plane, and transmit the first encoded page of the second plane to the memory device 120. Thereafter, the ECC engine 113 may load the first converted page P3_SP1 of the third plane from the buffer memory 112, generate a first encoded page of the third plane by performing an ECC encoding operation on the first converted page P3_SP1 of the third plane, and transmit the first encoded page of the third plane to the memory device 120. Thereafter, the ECC engine 113 may load the first converted page P4_SP1 of the fourth plane from the buffer memory 112, generate a first encoded page of the fourth plane by performing an ECC encoding operation on the first converted page P4_SP1 of the fourth plane, and transmit the first encoded page of the fourth plane to the memory device 120.

Thereafter, the ECC engine 113 may load the second converted page P1_SP2 of the first plane from the buffer memory 112, generate a second encoded page of the first plane by performing an ECC encoding operation on the second converted page P1_SP2 of the first plane, and transmit the second encoded page of the first plane to the memory device 120. Thereafter, the ECC engine 113 may load the second converted page P2_SP2 of the second plane from the buffer memory 112, generate a second encoded page of the second plane by performing the ECC encoding operation on the second converted page P2_SP2 of the second plane, and transmit the second encoded page of the second plane to the memory device 120. Thereafter, the ECC engine 113 may load the second converted page P3_SP2 of the third plane from the buffer memory 112, generate a second encoded page of the third plane by performing the ECC encoding operation on the second converted page P3_SP2 of the third plane, and transmit the second encoded page of the third plane to the memory device 120. Thereafter, the ECC engine 113 may load the second converted page P4_SP2 of the fourth plane from the buffer memory 112, generate a second encoded page of the fourth plane by performing an ECC encoding operation on the second converted page P4_SP2 of the fourth plane, and transmit the second encoded page of the fourth plane to the memory device 120. Since the remaining encoded pages are similar thereto, and accordingly, detailed descriptions thereof are omitted.

As described above, the storage device 100 may perform a multi-plane operation while performing a front state shaping operation. Reliability of the storage device 100 may be improved. Also, because the state shaping engine 116 uses the buffer memory 112, the state shaping engine 116 may not include a separate internal memory. Because a program time tPROG is sufficiently long, even when a front state shaping operation is performed, performance may not be reduced.

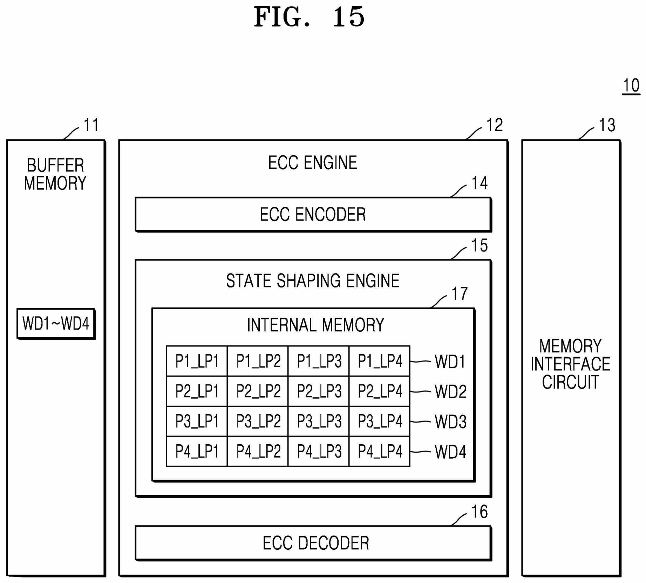

FIG. 15 is a diagram illustrating an operation of a storage controller (e.g., 10 of FIG. 4).

Referring to FIG. 15, the storage controller 10 may perform a multi-plane program operation. Generally, in order to perform the multi-plane program operation, the storage controller 10 may require an internal memory 17 having a greater capacity (or a size) than when a general program operation is performed. For example, when the general program operation is performed, the internal memory 17 is required to store the first write data WD1. When a multi-plane program operation is performed, the internal memory 17 is required to store the first to fourth write data WD1 to WD4. The storage controller 10 may include the internal memory 17 having a large capacity to perform the multi-plane operation. That is, due to the multi-plane operation, internal resources may need to increase.

For example, the buffer memory 11 may store the first to fourth write data WD1 to WD4 received from an external host. The first write data WD1 may correspond to a first plane, the second write data WD2 may correspond to a second plane, the third write data WD3 may correspond to a third plane, and the fourth write data WD4 may correspond to a fourth plane.

The state shaping engine 15 may receive the first to fourth write data WD1 to WD4 from the buffer memory 11. Because the state shaping engine 15 performs an on-the-fly encoding operation, the first to fourth write data WD1 to WD4 may be stored in the internal memory 17. The internal memory 17 may store the first to fourth write data WD1 to WD4.

The first write data WD1 may include a first logical page P1_LP1 of the first plane, a second logical page P1_LP2 of the first plane, a third logical page P1_LP3 of the first plane, and a fourth logical page P1_LP4 of the first plane. The second write data WD2 may include a first logical page P2_LP1 of the second plane, a second logical page P2_LP2 of the second plane, a third logical page P2_LP3 of the second plane, and a fourth logical page P2_LP4 of the second plane. The third write data WD3 may include a first logical page P3_LP1 of the third plane, a second logical page P3_LP2 of the third plane, a third logical page P3_LP3 of the third plane, and a fourth logical page P3_LP4 of the third plane. The fourth write data WD4 may include a first logical page P4_LP1 of the fourth plane, a second logical page P4_LP2 of the fourth plane, a third logical page P4_LP3 of the fourth plane, and a fourth logical page P4_LP4 of the fourth plane.

As described above, the storage controller 10 may require an increase in capacity of the state shaping engine 15 to support a multi-plane operation. To increase the internal resources, a chip size of the storage controller 10 may need to increase. However, because the storage controller 110 of FIG. 1 according to the embodiment may perform a front state shaping operation, use of the internal memory is not required. Because the storage controller 110 performs the front state shaping operation, the buffer memory 112 may store the first to fourth write data WD1 to WD4 or the first to fourth converted data SD1 to SD4. Accordingly, the storage controller 110 may prevent resources from increasing.

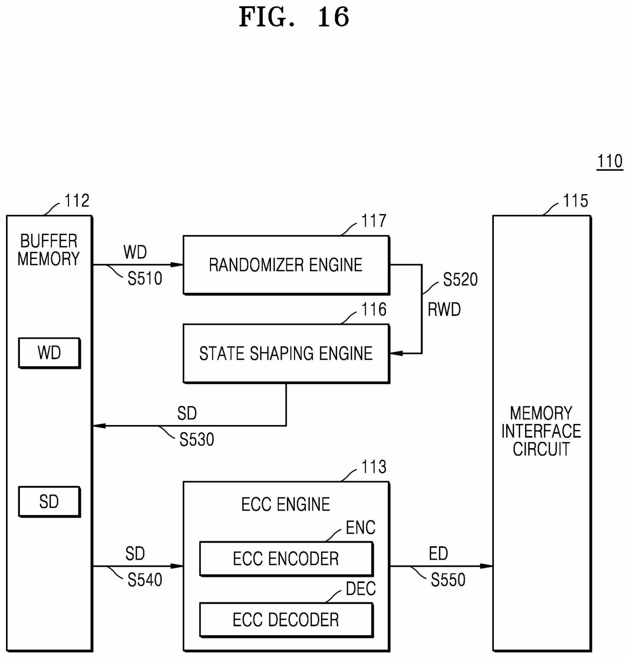

FIG. 16 is a diagram illustrating an example of an operation of a storage controller (e.g., 110 of FIG. 1) according to one or more embodiments.

Referring to FIG. 16, the storage controller 110 may further include a randomizer engine 117. The randomizer engine 117 may perform a randomization operation on the received data. Alternatively, the randomizer engine 117 may perform a de-randomization operation on the received data.

For example, in operation S510, the randomizer engine 117 may receive the write data WD from the buffer memory 112. The randomizer engine 117 may load the write data WD from the buffer memory 112. The randomizer engine 117 may perform a randomization operation on the write data WD. The randomizer engine 117 may generate randomized write data RWD.

In an embodiment, in operation S520, the randomizer engine 117 may transmit the randomized write data RWD to the state shaping engine 116. In an embodiment, the randomizer engine 117 may store the randomized write data RWD in the buffer memory 112.

The state shaping engine 116 may receive the randomized write data RWD. In an embodiment, the state shaping engine 116 may receive the randomized write data RWD from the randomizer engine 117. In an embodiment, the state shaping engine 116 may load the randomized write data RWD from the buffer memory 112. The state shaping engine 116 may perform a front state shaping operation based on the randomized write data RWD. The state shaping engine 116 may generate the converted data SD. In operation S530, the state shaping engine 116 may store the converted data SD in the buffer memory 112. In operation S540, the buffer memory 112 may provide the converted data SD to the ECC engine 113. The ECC engine 113 may perform an ECC encoding operation based on the converted data SD. The ECC engine 113 may generate encoded data ED by performing the ECC encoding operation. In operation S550, the ECC engine 113 may transmit the encoded data ED to the memory interface circuit 115. The ECC engine 113 may transmit the encoded data ED to the memory device 120.

As described above, the randomizer engine 117 may load a plurality of logical pages from the buffer memory 112. The randomizer engine 117 may generate a plurality of randomized pages by performing a randomization operation on the plurality of logical pages. The randomizer engine 117 may transmit the plurality of randomized pages to the state shaping engine 116.

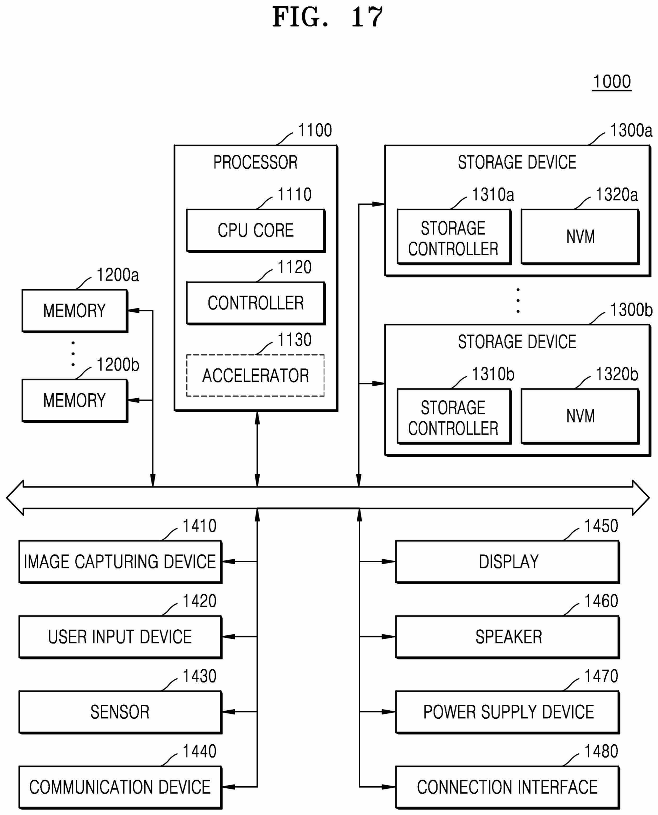

FIG. 17 is a diagram illustrating a system 1000 according to one or more embodiments.

The system 1000 of FIG. 17 may be a mobile system, such as a portable communication terminal (e.g., a mobile phone), a smartphone, a tablet personal computer (PC), a wearable device, a healthcare device, or an Internet of things (IOT) device. However, the system 1000 of FIG. 17 is not necessarily limited to the mobile system and may be, for example, a PC, a laptop computer, a server, a media player, or an automotive device (e.g., a navigation device).

Referring to FIG. 17, the system 1000 may include a main processor 1100, memories (e.g., 1200a and 1200b), and storage devices (e.g., 1300a and 1300b). In addition, the system 1000 may include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented as a general-purpose processor, a dedicated processor, or an application processor.

The main processor 1100 may include at least one CPU core 1110 and further include a controller 1120 configured to control the memories 1200a and 1200b and/or the storage devices 1300a and 1300b. In some embodiments, the main processor 1100 may include one or more of an application specific integrated circuit (ASIC), a field-programmable gate array (FPGA), a dedicated microprocessor, a microprocessor, a general purpose processor, or the like. In some embodiments, the main processor 1100 may include an accelerator 1130, which is a dedicated circuit for a high-speed data operation, such as an artificial intelligence (AI) data operation. The accelerator 1130 may include a graphics processing unit (GPU), a neural processing unit (NPU) and/or a data processing unit (DPU) and be implemented as a chip that is physically separate from the other components of the main processor 1100.

The memories 1200a and 1200b may be used as main memory devices of the system 1000. Although each of the memories 1200a and 1200b may include a volatile memory, such as SRAM and/or DRAM, each of the memories 1200a and 1200b may include non-volatile memory, such as a flash memory, phase-change RAM (PRAM) and/or resistive RAM (RRAM). The memories 1200a and 1200b may be implemented in the same package as the main processor 1100.

The storage devices 1300a and 1300b may serve as non-volatile storage devices configured to store data regardless of whether power is supplied thereto, and have larger storage capacity than the memories 1200a and 1200b. The storage devices 1300a and 1300b may respectively include storage controllers 1310a and 1310b and non-volatile memories (NVMs) 1320a and 1320b configured to store data via the control of the storage controllers 1310a and 1310b. Although the NVMs 1320a and 1320b may include flash memories having a two-dimensional (2D) structure or a three-dimensional (3D) V-NAND structure, the NVMs 1320a and 1320b may include other types of NVMs, such as a PRAM and/or an RRAM.

The storage devices 1300a and 1300b may be physically separated from the main processor 1100 and included in the system 1000 or implemented in the same package as the main processor 1100. In addition, the storage devices 1300a and 1300b may have types of solid-state devices (SSDs) or memory cards and be removably combined with other components of the system 1000 through an interface, such as the connecting interface 1480 that will be described below. The storage devices 1300a and 1300b may be devices to which a standard protocol, such as a universal flash storage (UFS), an embedded multi-media card (eMMC), or a non-volatile memory express (NVMe), is applied, without being limited thereto.

The image capturing device 1410 may capture still images or moving images. The image capturing device 1410 may include a camera, a camcorder, and/or a webcam.

The user input device 1420 may receive various types of data input by a user of the system 1000 and include a touch pad, a keypad, a keyboard, a mouse, and/or a microphone.

The sensor 1430 may detect various types of physical quantities, which may be obtained from the outside of the system 1000, and convert the detected physical quantities into electric signals. The sensor 1430 may include a temperature sensor, a pressure sensor, an illuminance sensor, a position sensor, an acceleration sensor, a biosensor, and/or a gyroscope sensor.

The communication device 1440 may transmit and receive signals between other devices outside the system 1000 according to various communication protocols. The communication device 1440 may include an antenna, a transceiver, and/or a modem.

The display 1450 and the speaker 1460 may serve as output devices configured to respectively output visual information and auditory information to the user of the system 1000.

The power supplying device 1470 may appropriately convert power supplied from a battery (not illustrated) embedded in the system 1000 and/or an external power source, and supply the converted power to each of components of the system 1000.

The connecting interface 1480 may provide connection between the system 1000 and an external device, which is connected to the system 1000 and capable of transmitting and receiving data to and from the system 1000. The connecting interface 1480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and a compact flash (CF) card interface.

In an embodiment, the storage devices 1300a and 1300b may each be the storage device 100 described with reference to FIGS. 1 to 16. The storage controllers 1310a and 1310b may each be the storage controller 110 described with reference to FIGS. 1 to 16. The storage controllers 1310a and 1310b may each include a state shaping engine and an ECC engine. The storage controllers 1310a and 1310b may each perform a front state shaping operation and a front state inversion operation. Accordingly, the storage devices 1300a and 1300b may reduce internal memory resources and be improved in reliability.

According to an embodiment, a storage device may perform a front state shaping operation and a front state inversion operation. Accordingly, the storage device may reduce internal resources. Also, a storage device with improved reliability may be provided.

At least one of the components, elements, modules or units (collectively "components" in this paragraph) represented by a block in the drawings, may be embodied as various numbers of hardware, software and/or firmware structures that execute respective functions described above, according to one or more example embodiments. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. For example, elements such as the state shaping engine, the ECC engine, and the randomizer engine described above according to one or more example embodiments may be implemented by a dedicated logic circuit of an ASIC or a FPGA, implemented by software run by the processor, and/or implemented by a hybrid module. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above example embodiments may be implemented in algorithms that execute on one or more processors. Furthermore, the components represented by a block or processing steps may employ any number of related art techniques for electronics configuration, signal processing and/or control, data processing and the like.

The descriptions made above are specific embodiments for implementing the disclosure. The disclosure may also include not only the embodiments described above but also embodiments that may be simply designed or easily changed. Also, the disclosure may also include technologies that may be easily modified and implemented based on the embodiments. Therefore, the disclosure should not be limited to the embodiments described above and should be determined by the claims and their equivalents as well as the claims of the disclosure.

While the disclosure has been particularly illustrated and described with reference to example embodiments thereof, it will be understood that various changes in form and details may be made therein without departing from the scope of the following claims.

## Claims

1. A storage device (100) comprising:
a memory device (120); and
a storage controller (110) configured to control the memory device (120) and communicate with an external host,
wherein the storage controller (110) comprises:
a buffer memory (112) configured to store write data (WD) received from the external host;
a state shaping engine (116) configured to receive the write data (WD) from the buffer memory (112), generate converted data (SD) by performing a front state shaping operation based on the write data (WD), and store the converted data (SD) in the buffer memory (112); and
an error correction code (ECC) engine (113) configured to receive the converted data (SD) from the buffer memory (112), generate encoded data (ED) by performing an ECC encoding operation based on the converted data (SD), and transmit the encoded data (ED) to the memory device (120).

2. The storage device (100) of claim 1, wherein the write data (WD) is stored in a first region (A1) of the buffer memory (112) and the converted data (SD) is stored in a second region (A2) of the buffer memory (112), the second region (A2) being different from the first region (A1).

3. The storage device (100) of claim 1, wherein the write data (WD) is stored in a first region (A1) of the buffer memory (112), and the converted data (SD) is stored in the first region (A1) by overwriting the converted data (SD) onto the write data (WD).

4. The storage device (100) of any preceding claim, wherein the write data (WD) comprises a first logical page to a fourth logical page (LP1 to LP4), and
wherein the state shaping engine (116) is further configured to simultaneously load the first logical page to the fourth logical page (LP1 to LP4).

5. The storage device (100) of claim 4, wherein the converted data (SD) comprises a first converted page to a fourth converted page (SP1 to SP4), and
wherein the state shaping engine (116) is further configured to generate the first to fourth converted pages (SP1 to SP4) by performing a front state shaping operation on the first to fourth logical pages (LP1 to LP4) by using a simultaneous comparison algorithm.

6. The storage device (100) of any preceding claim, wherein the state shaping engine (116) is further configured to receive a first logical page to a fourth logical page (P1_LP1 to P1_LP4) corresponding to a first plane included in the memory device (120) from the buffer memory (112), generate a first converted page to a fourth converted page (P1_SP1 to P1_SP4) by performing a front state shaping operation on the first to fourth logical pages (P1_LP1 to P1_LP4), and store the first to fourth converted pages (P1_SP1 to P1_SP4) in the buffer memory (112), and
wherein the state shaping engine (116) is further configured to receive a fifth logical page to an eighth logical page (P2_LP1 to P2_LP4) corresponding to a second plane included in the memory device (120) from the buffer memory (112), generate a fifth converted page to an eighth converted page (P2_SP1 to P2_SP4) by performing a front state shaping operation on the fifth to eighth logical pages (P2_LP1 to P2_LP4), and store the fifth to eighth converted pages (P2_SP1 to P2_SP4) in the buffer memory (112).

7. The storage device (100) of any preceding claim, further comprising a randomizer engine (117) configured to receive the write data (WD) from the buffer memory (112), generate randomized write data (RWD) by performing a randomization operation on the write data (WD), and transmit the randomized write data (RWD) to the state shaping engine (116).

8. The storage device (100) of any preceding claim, wherein the front state shaping operation is performed before the ECC encoding operation to reduce a number of bits corresponding to a target threshold voltage.

9. The storage device (100) of any preceding claim, wherein the ECC engine (113) is further configured to receive read data (RD) from the memory device (120), generate decoded data by performing an ECC decoding operation based on the read data (RD), and store the decoded data in the buffer memory (112), and
wherein the state shaping engine (116) is further configured to load the decoded data from the buffer memory (112) and generate inverted data (ID) by performing a front state inversion operation based on the decoded data.

10. An operating method of a storage controller comprising a buffer memory (112), a state shaping engine (116), and an error correction code (ECC) engine (113), the operating method comprising:
simultaneously loading, by the state shaping engine (116), a plurality of logical pages from the buffer memory (112);
generating, by the state shaping engine (116), a plurality of converted pages by performing a front state shaping operation based on the plurality of logical pages;
storing, by the state shaping engine (116), the plurality of converted pages in the buffer memory (112);
loading, by the ECC engine (113), the plurality of converted pages from the buffer memory (112);
generating, by the ECC engine (113), a plurality of encoded pages by performing an ECC encoding operation based on the plurality of converted pages; and
transmitting, by the ECC engine (113), the plurality of encoded pages to an external memory device.

11. The operating method of claim 10, wherein the simultaneously loading the plurality of logical pages comprises simultaneously loading the plurality of logical pages from a first region (A1) of the buffer memory (112), and
wherein the loading the plurality of converted pages comprises loading the plurality of converted pages from a second region (A2) of the buffer memory (112), the second region (A2) being different from the first region (A1).

12. The operating method of claim 10, wherein the simultaneously loading the plurality of logical pages comprises simultaneously loading the plurality of logical pages from a first region (A1) of the buffer memory (112), and
wherein the loading the plurality of converted pages comprises loading the plurality of converted pages from the first region (A1) of the buffer memory (112).

13. The operating method of any of claims 10-12, wherein the generating the plurality of converted pages comprises generating the plurality of converted pages by performing a front state shaping operation on the plurality of logical pages by using a simultaneous comparison algorithm.

14. The operating method of any of claims 10-13, wherein the simultaneously loading the plurality of logical pages comprises:
loading, by a randomizer engine (117) included in the storage controller (110), the plurality of logical pages from the buffer memory (112);
generating, by the randomizer engine (117), a plurality of randomized pages by performing a randomization operation on the plurality of logical pages; and
transmitting, by the randomizer engine (117), the plurality of randomized pages to the state shaping engine (116).

15. The operating method of any of claims 10-14, wherein the front state shaping operation is performed before the ECC encoding operation to reduce a number of bits corresponding to a target threshold voltage.
